# EUROPEAN PATENT APPLICATION

(11) **EP 0 941 021 A1**
(43) Date of publication of application: **08.09.1999**
(21) Application number: 98500066.0
(22) Date of filing: 06.03.1998
(51) Int. Cl.: H05K 3/42

(54) **Manufacturing process for printed-circuit boards with electrical connection between faces**

(71) Applicant: Easy Hole International, Ltd., Cork (IE)
(72) Inventor: Llongueras Arola, Juan, Madrid 28001 (ES)
(74) Representative: Maldonado Jordan, Julia

(57) **Abstract**

Starting from the base material of a board (1) that has each of its two faces surfaced with copper coating (2), the circuit is defined by means of the partial elimination of the copper by chemical etching. Following this, the punching of the unit is undertaken in order to obtain the bore holes (5) through which the electrical connection between the two faces of the circuit will be preformed. This connection is performed by means of a chemical metallizing in which a metal layer (8) from a nickel-phosphorous base alloy is applied to the holes (5) and to the area surrounding them, leaving the board, after the application of a solder mask, identification ink and conductive inks, in a condition to pass under the soldering jet, which will fill the metallized bore holes (5) with a tin/lead mass.

## Description

### PURPOSE OF THE INVENTION:

The present invention refers to a new manufacturing process for printed-circuit boards, especially boards with electrical connections between faces, that supposes a notable simplification and a subsequent reduction in cost compared to conventional processes.

The process is ideally suited for the type of printed-circuit boards used in the automobile industry and for electronic consumer goods such as video, hi-fi, television and telephony.

### ANTECEDENTS TO THE INVENTION:

In the invention's preferred sphere of practical application, the base materials used to obtain boards are fibreglass- and epoxy resin-based "FR-4" and "CEM-1", which is a material composed of Fiberglas, paper and epoxy resin.

This type of board, according to conventional techniques, would first be metallized, then punched, metallized again and finally etched, leading to the elimination of the two copper layers in order to define the tracks.

This solution has its own problematic repercussions that centre on the following aspects:
- Part of the hole remains unused.
- Poor characteristics of electrical conductivity are obtained.
- Metallization is performed on expensive laminates.
- The process involves an extremely long period of application.
- Highly contaminating electrolyte baths are used.

### DESCRIPTION OF THE INVENTION:

The process proposed by the invention resolves the aforementioned repercussions in a highly satisfactory way, considering that it renders bore holes useful for inserting components, leading to the reduction in size of the printed circuit in addition to a substantial improvement in the electrical characteristics of the printed circuit compared to the classic surfacing of the holes with "silver ink". Metallization is also performed on laminates that cost less than the FR-4, avoiding the typical problems that traditional copper metallization has on these laminates.

More concretely, the process proposed by the invention enables bore holes to be used by chemically making a metallic deposit. This is to say, without electrolyte processes on one or more of the holes of the printed circuit, depending on its needs.

This process can be applied to the majority of base materials available on the market, and, in particular, to the following types: CEM-3, CEM-1, FR-2 and FR-1.

In order to obtain this metallization, silk-screen impressions are all that are used. This supposes a series of advantages that centre on the following aspects:
- Greater format size of the circuit board, which translates into an increase in productivity.
- Reduced cost in the tool rigs used.
- Improvements of the electrical benefits of the bore hole.
- Better resistance to climatic and thermal shock tests.

The manufacturing process begins with the preparation of the base material by means of wet-process polishing, leaving the copper in perfect condition for a second phase, silk-screening, in which the copper pattern of the circuit is impressed and the excess copper is eliminated by means of chemical etching.

More specifically, prior to the preparation of the copper surface, impression is performed with inks resistant to the chemical processes of metallization that will connect the two faces of the circuit, in addition to its punching.

Following this, chemical metallization is performed on those holes that will connect the two faces of the circuit, having planned―with this constituting one of the essential characteristics of the invention―that this metallization is performed with a nickel-phosphorous alloy in which the phosphorous is used in a proportion that ranges between 11% and 13%.

Lastly, a soldering mask is applied, along with identifying inks and other conductive inks. A soldering jet then ensures that the metallized bore holes are completely filled with tin/lead.

### DESCRIPTION OF DIAGRAMS:

In order to complement the present description and with the aim of helping to better understand the characteristics of the invention, as per a preferred example of its practical performance, a set of drawings, of an illustrative, non-restrictive nature, is used to represent the following:
Figure 1: Shows a schematic cut-away representation of the base material, which constitutes the starting point to the manufacturing process of the printed-circuit boards that constitute the target of the present invention.
Figure 2: Shows, in a representation similar to that of Figure 1, the etching phase.
Figure 3: Shows the appearance of the board at the end of the etching phase.

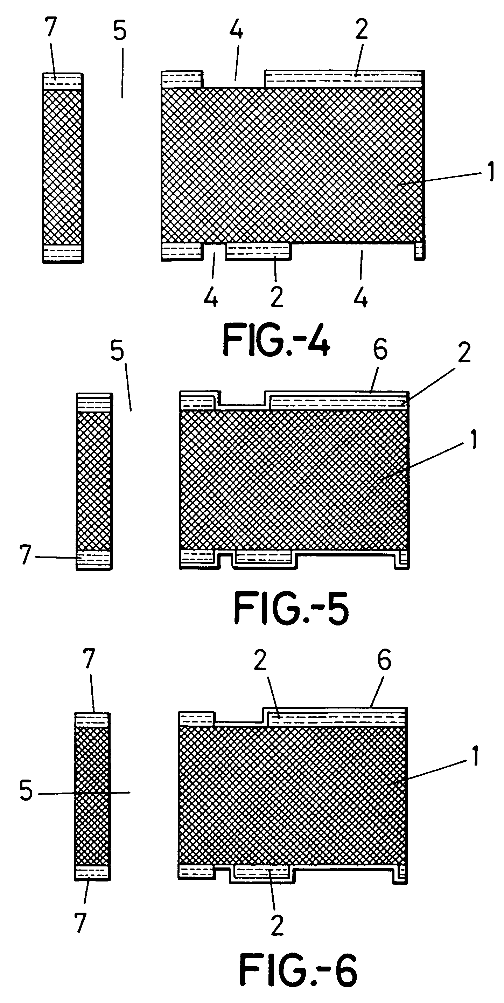

Figure 4: Shows the appearance of the board after the punching phase.
Figure 5: Shows the impression phase with resistant inks.
Figure 6: Shows how the resistant ink leaves those parts of the board where the chemical metallization is going to occur clear.
Figure 7: Shows the same board as the previous Figure after the metallization of the punched holes and with other normal holes added.
Figure 8: Shows the board after the silk-screen impression phase of the soldering mask.
Figure 9: Shows, lastly, the printed-circuit board after passing under the soldering jet.

### PREFERRED REALISATION OF THE INVENTION:

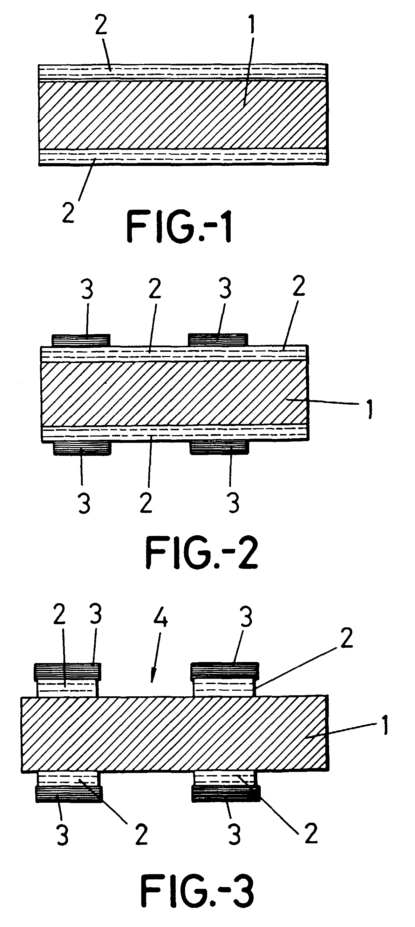

In Figure 1, it can be seen how the process begins with the base material of a board (1) that has its faces equally covered by copper (2). Following this, by applying a resistant etching ink (3), the copper areas (4) needed to define the circuit are eliminated, as it can be seen in Figure 3.

Following this, the unit is punched, obtaining the bore holes (5) that are, in their number and positioning, suitable for the electrical connection between the two faces of the board as well as for the insertion of electronic components of the circuit.

The unit again undergoes an impression with inks (6) resistant to the chemical processes of metallization in order to leave the areas (7) meant to connect the two faces of the circuit through the bore holes (5) clear.

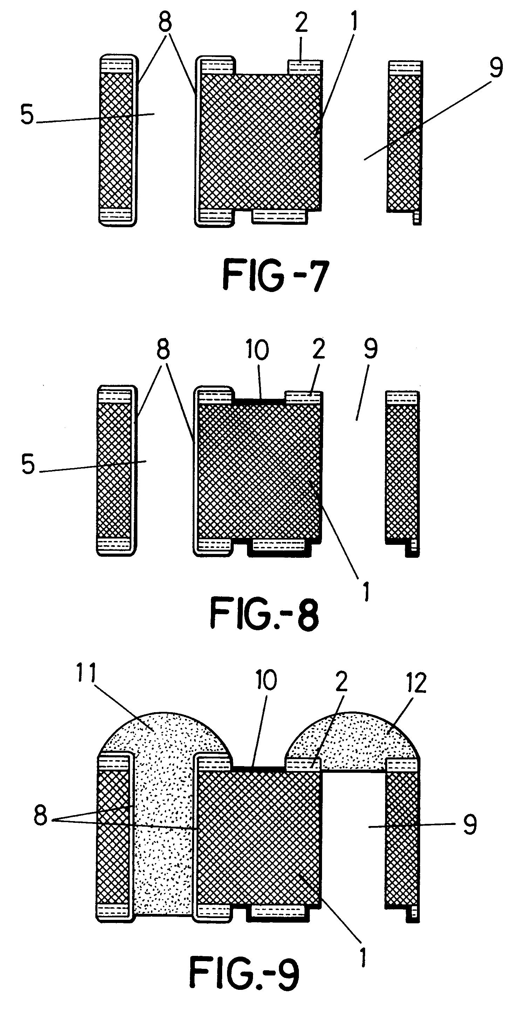

The chemical metallization phase is then carried out, and, as it has been stated previously, it is performed with a nickel-phosphorous alloy (8), as seen in Figure 7. This chemical metallization (8) affects only those bore holes (5) where the connection between the two faces of the board is going to be carried out, while the normal holes (9) will not be affected by this metallizing.

Following this, and after the copper surface (2) has been suitably prepared, identifying inks and other conductive inks (10) are applied in order to improve adhesion so that the soldering mask represented in Figure 8 enables, after the soldering jet phase (shown in Figure 9), the metallized bore holes (5) to be completely filled with a tin/lead mass (11), while in the normal holes (9) the soldering mass (12) can be applied to only one of their openings, as is shown in Figure 9.

It is felt that a more detailed description is not required for any expert in the field to recognise the scope of the invention and the advantages that are to be derived from it.

The materials, form, size and disposition of the elements will be susceptible to variation so long as it does not suppose an alteration in the essence of the invention.

The terms that have been used to write up this report should always be taken in their broadest, non-restrictive sense.

## Claims

1. Manufacturing process for printed-circuit boards with electrical connection between faces, characterised by the following operational phases:
- Preparation of base material by means of wet-process polishing in order to leave the copper in a condition for impression.
- Resistant impression, by means of silk-screening, of the copper pattern of the circuit.
- Elimination of the excess copper by means of chemical etching in order to define the circuit.
- Punching of the material in order to finish the circuit, using the bore holes for the electrical connection between the faces of the circuit.
- Impression with inks resistant to the chemical processes of metallization that will connect the two faces of the circuit.
- Chemical metallization for the electrical connection between faces as well as for the insertion of components.
- Preparation of the copper surface for adherence to the soldering mask and to identifying and conductive inks.
- Passage under the soldering jet to fill the metallized bore holes with tin/lead.

2. Manufacturing process for printed-circuit boards with electrical connection between faces, as per Claim #1, characterised by the chemical metallization phase that is performed with a nickel-phosphorous alloy.

3. Manufacturing process for printed-circuit boards with electrical connection between faces, as per Claim #2, characterised by the aforementioned nickel-phosphorous alloy, in which the proportion of phosphorous accounts for between 11% and 13%.
